# EUROPÄISCHE PATENTSCHRIFT

(11) **EP 3 813 242 B1**
(45) Veröffentlichungstag und Bekanntmachung des Hinweises auf die Patenterteilung: **18.01.2023**
(21) Anmeldenummer: 20201571.5
(22) Anmeldetag: 13.10.2020
(51) Int. Cl.: H02M 3/335, H02M 3/158, H03F 3/183, H03F 3/217

(54) **SCHALTNETZTEIL SOWIE EIN VERFAHREN ZUM BETREIBEN DES SCHALTNETZTEILS ALS VERSTÄRKER**
SWITCH MODE POWER SUPPLY AND METHOD FOR OPERATING THE SWITCH MODE POWER SUPPLY AS AMPLIFIER
CONVERTISSEUR CONTINU-CONTINU ET SON PROCÉDÉ DE FONCTIONNEMENT

(30) Priorität: 21.10.2019 DE 102019128299
(43) Veröffentlichungstag der Anmeldung: 28.04.2021
(73) Patentinhaber: Kögel, Reinhard, 78086 Brigachtal (DE); Hell, Melina, 95239 Zell im Fichtelgebirge (DE); Willinger, Frank, 75223 Niefern-Öschelbronn (DE)
(72) Erfinder: Kögel, Reinhard, 78086 Brigachtal (DE); Hell, Melina, 95239 Zell im Fichtelgebirge (DE); Willinger, Frank, 75223 Niefern-Öschelbronn (DE)
(74) Vertreter: Westphal, Mussgnug & Partner Patentanwälte mbB

(56) Entgegenhaltungen:
- DE-A1-102014 211 853
- US-A1- 2010 102 672

## Beschreibung

Die Erfindung betrifft ein Schaltnetzteil nach dem Oberbegriff des Anspruchs 1 sowie ein Verfahren zum Betreiben des Schaltnetzteils als Verstärker.

Ein solches Schaltnetzteil ist z.B. aus US 2010/0102672 A1 bekannt. Ein weiteres Schaltnetzteil beschreibt die DE 10 2014 211 853 A1. Ein weiteres Schaltnetzteil beschreibt die DE 10 2014 211 853 A1.

Schaltnetzteile sind Baugruppen, die eine Eingangsspannung in eine gewünschte Ausgangsspannung wandeln.

Analogverstärker werden eingesetzt, um aus einem Eingangssignal eine Wechselspannung oder einen Wechselstrom am Verstärkerausgang zu erzeugen und sind in Klassen A, AB, B, C und D klassifiziert, wobei Verstärker der Klasse D für analoge Eingangssignale ein Pulsweitenmodulationsverfahren (PWM-Verfahren) benutzen und daher als PWM-Verstärker bezeichnet werden. Solche PWM-Verstärker werden als Audioverstärker verwendet, da diese gegenüber den Verstärkern der Klasse A/B eine höhere Energieeffizienz aufweisen.

Der Erfindung liegt die Aufgabe zugrunde, ein Schaltnetzteil zu schaffen, mit welchem sowohl kleine als auch positive und negative Lastspannungen als Ausgangsspannungen beliebiger Form erzeugbar sind und ein solches Schaltnetzteil daher als Verstärker einsetzbar ist. Ferner ist es Aufgabe, ein Verfahren zum Betreiben eines solchen Schaltnetzteils anzugeben.

Die erstgenannte Aufgabe wird gelöst durch ein Schaltnetzteil mit den Merkmalen des Patentanspruchs 1.

Ein solches Schaltnetzteil zur Erzeugung einer Lastspannung aus der Differenz einer ersten und zweiten Ausgangsspannung ist anschließbar an eine eine Eingangsgleichspannung bereitstellende Eingangsgleichspannungsquelle, und umfasst folgende Komponenten:
- einen Übertrager mit einer ersten Wicklung, welche in Serie mit einem ersten getakteten Schaltmittel geschaltet ist und einer zweiten Wicklung, welche in Serie mit einem zweiten getakteten Schaltmittel geschaltet ist,
- ein mit der ersten Wicklung verbundener erster Ausgangskondensator, an welchem die erste Ausgangsspannung abgreifbar ist,
- ein mit der zweiten Wicklung verbundener zweiter Ausgangskondensator, an welchem die zweite Ausgangsspannung abgreifbar ist,
- eine Steuerschaltung, welche mit dem ersten und dem zweiten getakteten Schaltmittel verbunden ist, wobei die Steuerschaltung derart ausgebildet ist, dass entweder
- zur Erhöhung der Lastspannung in einer Einschaltphase des ersten getakteten Schaltmittels Energie aus dem ersten Ausgangskondensator und aus der Eingangsgleichspannungsquelle in dem Übertrager speicherbar ist und in der Ausschaltphase die gespeicherte Energie auf den zweiten Ausgangskondensator übertragbar ist, oder
- zur Erniedrigung der Lastspannung (U_{L}) in einer Einschaltphase des zweiten getakteten Schaltmittels Energie aus dem zweiten Ausgangskondensator und aus der Eingangsgleichspannungsquelle in dem Übertrager speicherbar ist und in der Ausschaltphase die gespeicherte Energie auf den ersten Ausgangskondensator übertragbar ist, wobei zusätzlich
- ein bezüglich der Eingangsgleichspannung in Durchlassrichtung geschaltetes erstes Eingangsgleichrichtelement vorgesehen ist, welches mit der ersten Wicklung verbunden ist, und
- ein bezüglich der Eingangsgleichspannung in Durchlassrichtung geschaltetes zweites Eingangsgleichrichtelement vorgesehen ist, welches mit der zweiten Wicklung verbunden ist.

Bei diesem erfindungsgemäßen Schaltnetzteil wird in Abhängigkeit der Energieanforderung der Last zur Erhöhung der Lastspannung über die erste Wicklung Energie gespeichert und somit die erste Ausgangsspannung bis auf die Eingangsgleichspannung verkleinert und anschließend über die zweite Wicklung diese gespeicherte Energie wieder abgegeben und damit die zweite Ausgangsspannung wieder vergrößert. Sowohl in der Phase der Energiespeicherung als auch in der Phase der Energieabgabe wird die Last bestromt, da die Lastspannung als Differenzspannung der beiden Ausgangsspannungen zunimmt, sowohl wenn die erste Ausgangsspannung geringe wird als auch wenn die zweite Ausgangsspannung größer wird. Dies gilt auch dann, wenn die Lastspannung erniedrigt werden soll, also Energie über die zweite Wicklung gespeichert wird und damit die zweite Ausgangsspannung bis auf die Eingangsgleichspannung erniedrigt wird und anschließend die gespeicherte Energie über die erste Wicklung wieder abgegeben und damit die erste Ausgangsspannung vergrößert wird.

Dieses erfindungsgemäße Schaltnetzteil besteht lediglich aus einem Übertrager mit zwei Schaltelementen, die in Abhängigkeit davon angesteuert werden, ob eine positive oder negative Lastspannung oder eine alternierende Lastspannung erzeugt werden soll.

Dadurch dass die Lastspannung als Ausgangsspannung durch die Differenz von der ersten Ausgangsspannung und der zweiten Ausgangsspannung gebildet wird, lässt sich in einfacher Weise eine positive Lastspannung erzeugen, wenn die zweite Ausgangsspannung größer als die erste Ausgangsspannung ist oder eine negative Lastspannung, wenn die erste Ausgangsspannung größer als die zweite Ausgangsspannung ist. Gleichzeitig lassen sich beliebig kleine Lastspannungen erzeugen. Damit ist es bspw. möglich, eine beliebige Ausgangsspannung derart zu erzeugen, wie es zum Ansteuern eines Sinusgenerators, zum Ansteuern von Elektromotoren oder zum Einspeisen in ein Netzsystem erforderlich ist. Ferner ist damit die Möglichkeit gegeben, auch ein Audiosignal zum Ansteuern von Lautsprechern zu erzeugen.

Durch die Möglichkeit, die Lastspannung aktiv anzuheben und aktiv abzusenken, kann dieses Schaltnetzteil auch als Spannungsregler eingesetzt werden, um eine Versorgungsspannung zu stabilisieren.

Mit diesem erfindungsgemäßen Schaltnetzteil erfolgt eine stetige Stromlieferung an die Last und damit wird ein kleiner Stromripple sichergestellt.

Nach einer vorteilhaften Ausgestaltung der Erfindung ist es vorgesehen, dass
- das erste Schaltmittel einen ersten Halbleiterschalter und eine erste Freilaufdiode umfasst, und
- das zweite Schaltmittel einen zweiten Halbleiterschalter und eine zweite Freilaufdiode umfasst.

Vorzugsweise können diese Halbleiterschaltern als MOSFET-Halbleiterschalter ausgeführt werden, so dass anstelle der Freilaufdioden die in diesen MOSFET-Halbleiterschaltern enthaltenen Bodydioden benutzt werden können.

Um die Effizienz weit zu erhöhen, können die beiden MOSFET-Halbleiterschalter als Synchron-MOSFET gegenphasig getaktet werden, so dass auf Freilaufdioden als externe Dioden verzichtet werden kann.

Eine weitere bevorzugte Ausführungsform der Erfindung sieht vor, dass
- ein erstes Ausgangsgleichrichtelement bezüglich der Eingangsgleichspannung in Durchlassrichtung mit dem ersten Ausgangskondensator verbunden ist,
- ein zweites Ausgangsgleichrichtelement bezüglich der Eingangsgleichspannung in Durchlassrichtung mit dem zweiten Ausgangskondensator verbunden ist, und
- ein Rekuperationskondensator zur Energierückgewinnung mit dem ersten und zweiten Ausgangsgleichrichtelement verbunden ist.

Damit ist möglich, bspw. im Falle der Verwendung eines Elektromotors als Last eine Energierückgewinnung zu realisieren, wobei vorzugsweise zur Energierückführung ein den Rekuperationskondensator mit der Eingangsgleichspannungsquelle verbindender Tiefsteller vorgesehen ist.

Des Weiteren ist weiterbildungsgemäß ein Siebkondensator vorgesehen, welcher den ersten Ausgangskondensator mit dem zweiten Ausgangskondensator verbindet.

Ein solches erfindungsgemäßes Schaltnetzteil als Einphasen-System kann in vorteilhafter Weise für den Aufbau eines 3-Phasen-Schaltnetzteils zur Erzeugung einer 3-Phasen-Lastspannung eingesetzt werden. Hierfür werden erfindungsgemäß drei Einphasen-Schaltnetzteile gemäß den Merkmalen des Patentanspruchs 8 eingesetzt.

Die zweitgenannte Aufgabe wird gelöst durch ein Verfahren mit den Merkmalen des Patentanspruchs 9.

Dieses Verfahren zum Betreiben eines erfindungsgemäß ausgebildeten Schaltnetzteils als Verstärker wird durchgeführt, indem
a) ein von einer Signalquelle erzeugtes Eingangssignal bereitgestellt wird,
b) eine Differenz zwischen der um den Verstärkungsfaktor verminderten Lastspannung und dem Eingangssignal als Regelsignal gebildet wird,
c) aus dem Regelsignal ein Vorzeichensignal als Richtungsinformation des Regelsignals erzeugt wird,
d) in Abhängigkeit des Regelsignals ein erstes PWM-Signal und ein zweites PWM-Signal erzeugt wird,
e) in Abhängigkeit des Vorzeichensignals das erste PWM-Signal an das erste Schaltmittel oder das zweite PWM-Signal an das zweite Schaltmittel angelegt wird, und
f) bei einer PWM-Pulsbreite entweder des an dem ersten Schaltmittel anliegenden ersten PWM-Signals oder des an dem zweiten Schaltmittel anliegenden zweiten PWM-Signals kleiner als eine minimale Pulsbreite in Abhängigkeit der von dem Vorzeichensignal angezeigten Richtungsinformation des Regelsignals entweder das zweite PWM-Signal an das zweite Schaltmittel oder das erste PWM-Signal an das erste Schaltmittel angelegt wird.

Mit einem solchen Verfahren zur Regelung des erfindungsgemäßen Schaltnetzteils als Audioverstärker wird eine verzerrungsfreie Regelung sichergestellt. Bei diesem erfindungsgemäßen Verfahren wird das Vorzeichen der Regelung immer in einem optimalen Zeitpunkt umgeschaltet, dann nämlich, wenn die Pulsbreite desjenigen PWM-Signals, welches gerade an dem ersten oder zweiten Schaltmittel anliegt, eine minimale Pulsbreite unterschreitet. Dieser Zeitpunkt ist unabhängig von der Phasenlage des Audiosignals und ist nur abhängig von der Pulsbreite des ersten oder des zweiten PWM-Signals. Das Vorzeichensignal bestimmt, ob entweder das erste PWM-Signal dem ersten Schaltmittel oder das zweite PWM-Signal dem zweiten Schaltmittel zugeführt wird. Somit wird in Abhängigkeit des Vorzeichensignals entweder Energie dem ersten Ausgangskondensator entnommen, in dem Übertrager gespeichert und dem zweiten Ausgangskondensator wieder zugeführt oder es wird Energie dem zweiten Ausgangskondensator entnommen, in dem Übertrager gespeichert und dem ersten Ausgangskondensator wieder zugeführt.

Die Erfindung wird nachfolgend anhand von Ausführungsbeispielen unter Bezugnahme auf die beigefügten Figuren ausführlich beschrieben. Es zeigen:
- Figur 1: ein Schaltbild eines Schaltnetzteils als Ausführungsbeispiel der Erfindung,
- Figur 2: Zeit-Strom- und Zeit-Spannungs-Diagramme zur Erläuterung der Funktion des Schaltnetzteils nach Figur 1,
- Figur 3: ein Blockschaltbild zur Erzeugung von PWM-Signalen, die den Schaltelementen des Schaltnetzteils nach Figur 1 zugeführt werden,
- Figur 4: Zeit-PWM-Signal-Diagramme zur Erläuterung der Erzeugung von PWM-Signalen zur Steuerung des Schaltnetzteils nach Figur 1,
- Figur 5: weitere Zeit-PWM-Signal-Diagramme zur Erläuterung der Erzeugung von PWM-Signalen zur Steuerung des Schaltnetzteils nach Figur 1, und
- Figur 6: ein Schaltbild eines 3-Phasen-Schaltnetzteils als weiteres Ausführungsbeispiel der Erfindung.

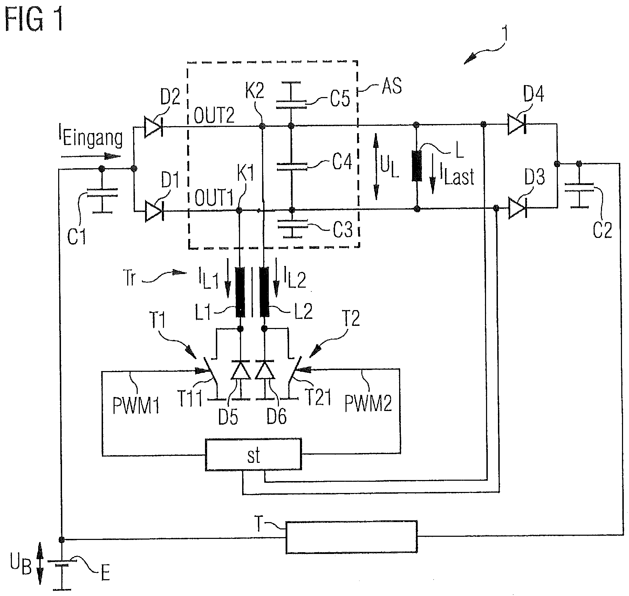

Die Figur 1 zeigt ein Schaltbild eines erfindungsgemäßen Schaltnetzteils 1 mit einem Übertrager Tr, welcher eine erste Wicklung L1 und eine zweite Wicklung L2 umfasst. Die zweite Wicklung L2 ist gegensinnig zur ersten Wicklung L1 gewickelt.

Eine Reihenschaltung aus der ersten Wicklung L1 und einem ersten Schaltmittel T1, welches aus einem MOSFET-Halbleiterschalter T11 und einer parallel zu demselben geschalteten ersten Freilaufdiode D5 besteht, ist über eine als Diode ausgeführtes erstes Eingangsgleichrichtelement D1 an eine eine Eingangsgleichspannung U_{B} erzeugende Eingangsgleichspannungsquelle E angeschlossen.

Ferner ist eine weitere Reihenschaltung aus der zweiten Wicklung L2 und einem Schaltmittel T2, welches aus einem MOSFET-Halbleiterschalter T21 und einer parallel zu demselben geschalteten zweiten Freilaufdiode D6 über eine als Diode ausgeführtes zweites Eingangsgleichrichtelement D2 ebenso an die Eingangsgleichspannungsquelle E angeschlossen.

Hierbei ist die positive Eingangsgleichspannung U_{B} an die Anoden der beiden Eingangsgleichrichtelemente D1 und D2 angelegt. Ferner ist an diesen Anoden der beiden Eingangsgleichrichtelemente D1 und D2 ein Eingangskondensator C1 gegen Masse angeschlossen.

Der erste MOSFET-Halbleiterschalter T11 ist mittels der ersten Freilaufdiode D5 und der zweite MOSFET-Halbleiterschalter T21 ist mittels der zweiten Freilaufdiode D6 überbrückbar, wobei diese beiden Dioden bzgl. der Eingangsgleichspannung U_{B} in Sperrrichtung geschaltet sind.

An einem die erste Wicklung L1 mit dem ersten Eingangsgleichrichtelement D1 verbindenden Knotenpunkt K1 ist eine erste Ausgangsspannung Out1 und an einem die zweite Wicklung L2 mit dem zweite Eingangsgleichrichtelement D2 verbindenden Knotenpunkt K2 ist eine zweite Ausgangsspannung Out2 abgreifbar. Die Differenz dieser beiden Ausgangsspannungen Out1 und Out2 liegt als Lastspannung U_{L} an einer Last L an.

Die beiden Ausgangsspannungen Out1 und Out2 werden mittels einer Ausgangsschaltung AS in Verbindung mit den beiden angesteuerten Schaltelementen T1 und T2 erzeugt.

Die Ausgangsschaltung As umfasst einen ersten Ausgangskondensator C3, welcher mit dem ersten Knotenpunkt K1 gegen Masse verbunden ist, einen zweiten Ausgangskondensator C5, welcher mit dem zweiten Knotenpunkt K2 gegen Masse verbunden ist. Schließlich verbindet ein Siebkondensator C4 die beiden Knotenpunkte K1 und K2, bzw. die beiden Ausgangskondensatoren C3 und C5.

Ferner ist der erste Knotenpunkt K1, welcher über das erste Eingangsgleichrichtelement D1 mit der Eingangsspannung U_{B} verbunden ist, mit einem bezüglich der Eingangsgleichspannung U_{B} in Durchlassrichtung geschalteten und als Diode ausgebildeten ersten Ausgangsgleichrichtelement D3 und der zweite Knotenpunkt K2, welcher über das zweite Eingangsgleichrichtelement D2 ebenso mit der Eingangsgleichspannung U_{B} verbunden ist, mit einem bezüglich der Eingangsgleichspannung U_{B} in Durchlassrichtung geschalteten und ebenso als Diode ausgebildeten zweiten Ausgangsgleichrichtelement D4 verbunden. Die Kathoden dieser beiden Ausgangsgleichrichtelemente D3 und D4 sind zusammengeführt und mit einem Tiefsteller T verbunden, der seinerseits an die Eingangsgleichspannungsquelle E angeschlossen ist. Ferner sind die beiden verbundenen Kathoden der Ausgangsgleichrichtelemente D3 und D4 über einen Rekuperationskondensator C2 mit Masse verbunden. Somit ist der erste Knotenpunkt K1 über das Ausgangsgleichrichtelement D3 mit dem Rekuperationskondensator C2 und der zweite Knotenpunkt K2 über das Ausgangsgleichrichtelement D4 ebenso mit dem Rekuperationskondensator C2 verbunden. Die beiden Ausgangsgleichrichtelemente D3 und D4 dienen zusammen mit dem Tiefsteller T der Energierückgewinnung.

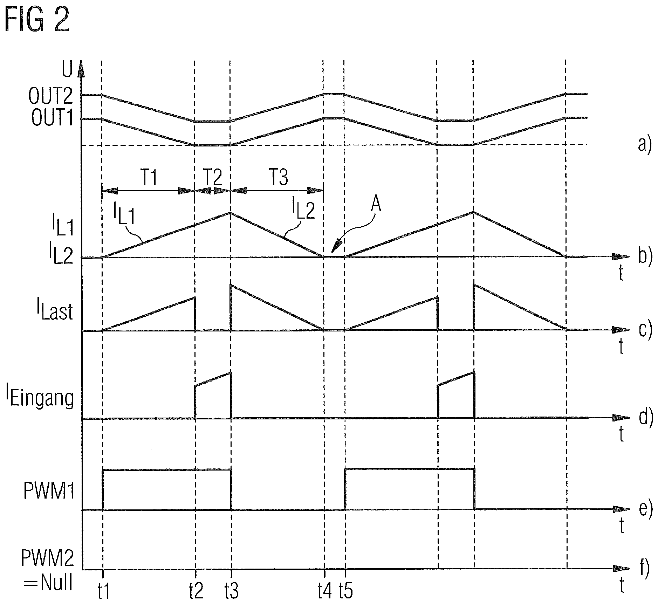

Die beiden PWM-Signale PWM1 und PWM2 werden von einer Steuerschaltung St erzeugt, wobei in Abhängigkeit eines Vorzeichensignals VZ (vgl. Figur 2) entweder das erste PWM-Signal PWM1 der Steuerelektrode des ersten MOSFET-Halbleiterschalters T11 oder das zweite PWM-Signal PWM2 der Steuerelektrode des zweiten MOSFET-Halbleiterschalters T21 zugeführt. Somit ist entweder nur das erste PWM-Signal PWM1 oder nur das zweite PWM-Signal PWM2 aktiv. Zur Erzeugung der beiden PWM-Signale PWM1 und PWM2 werden der Steuerschaltung St die beiden Ausgangsspannungen Out1 und Out2, d. h. die Lastspannung U_{L} zugeführt.

Die Last L kann als Elektromotor oder als Lautsprecher ausgeführt sein sowie zur Netzeinspeisung oder zur Spannungsregelung dienen.

Im Folgenden wird die Funktion des Schaltnetzteils 1 gemäß Figur 1 erläutert.

Wird die Eingangsgleichspannungsquelle E an die beiden Eingangsgleichrichtelemente D1 und D2 angeschlossen, werden über diese beiden Dioden der erste Ausgangskondensator C3 und der zweite Ausgangskondensator C5 aufgeladen. Infolgedessen sind die beiden Ausgangsspannungen Out1 und Out2 gleich groß und damit ist deren Differenz, also die Lastspannung U_{L} Null. Damit bleibt auch die Spannung an dem Siebkondensator C4 Null.

Im Folgenden werden zwei Fälle unterschieden, zum einen der Fall, dass die Lastspannung U_{L} ausgehend von dem Wert Null erhöht wird und zum anderen dass die Lastspannung U_{L} ausgehend von dem Wert Null erniedrigt wird.

Im Falle der Erhöhung der Lastspannung U_{L} wird das erste PWM-Signal PWM1 ausschließlich dem ersten Schaltmittel T1, also der Steuerelektrode des ersten MOSFET-Halbleiterschalters T11 zugeführt, während an dem zweiten Schaltmittel T2, also an der Steuerelektrode des zweiten MOSFET-Halbleiterschalters T21 kein Signal anliegt.

Im Falle der Erniedrigung der Lastspannung U_{L} wird das zweite PWM-Signal PWM2 ausschließlich dem zweiten Schaltmittel T2, also der Steuerelektrode des zweiten MOSFET-Halbleiterschalters T21 zugeführt, während an dem ersten Schaltmittel T1, also an der Steuerelektrode des ersten MOSFET-Halbleiterschalters T11 kein Signal anliegt.

Der erstgenannte Fall wird anhand der Zeit-Diagramme gemäß Figur 2 erläutert.

Das Zeit-Spannungsdiagramm gemäß Figur 2a) zeigt den Spannungsverlauf der beiden Ausgangsspannungen Out1 und Out2, wobei die zweite Ausgangsspannung Out2 größer als die erste Ausgangsspannung Out1 ist, damit ist die Lastspannung U_{L} positiv. Das Zeit-Stromdiagramm nach Figur 2b) zeigt den Verlauf des Stromes I_{L1} durch die erste Wicklung L1 des Übertragers Tr, während das Das Zeit-Stromdiagramm nach Figur 2c) den Verlauf des Laststromes I_{Last} durch die Last L darstellt. Der Verlauf des Eingangsstromes I_{Eingang}, welcher der Eingangsgleichspannungsquelle E entnommen wird, ist in dem Diagramm nach Figur 2d) dargestellt. Den exemplarischen Verlauf eines ersten PWM-Signals PWM1 zeigt das Diagramm nach Figur 2e), während der Verlauf des zugehörigen zweiten PWM-Signals PWM2 in Figur 2f) dargestellt ist, welches den Wert Null aufweist.

Soll die Lastspannung U_{L} erhöht werden, so wird das erste PWM-Signal PWM1 an den ersten MOSFET-Halbleiterschalter T11 angelegt, wodurch dieser gemäß dem Diagramm nach Figur 2f) zu einem Zeitpunkt t1 eingeschaltet wird. Dies führt zu einer Energieentnahme aus dem ersten Ausgangskondensator C3 während eines Zeitabschnittes T1, wodurch die erste Ausgangsspannung Out1 abgesenkt wird. Durch die Verkleinerung der ersten Ausgangsspannung Out1 an dem ersten Ausgangskondensator C3 wird die Differenzspannung an der Last U_{L}, also die Lastspannung U_{L} vergrößert, was zu einer Zunahme des Stromes I_{Last} durch die Last L führt (vgl. Diagramm nach Figur 2c)). Die Abnahme der ersten Ausgangsspannung Out1 endet in einem Zeitpunkt t2, in welchem die abgesenkte erste Ausgangsspannung Out1 die Eingangsgleichspannung U_{B} erreicht hat. Dadurch kann die erste Ausgangsspannung Out1 nicht weiter abgesenkt werden, sondern es wird in dem sich anschließenden Zeitabschnitt T2 bis zum Zeitpunkt t3 Energie aus der Eingangsgleichspannungsquelle E entnommen, weshalb gemäß dem Diagramm nach Figur 2d) ein entsprechender Eingangsstrom I_{Eingang} fließt.

Die aus dem ersten Ausgangskondensator C3 und der Eingangsgleichspannungsquelle E entnommene Energie wird in dem Übertrager Tr gespeichert.

Mit dem Ausschalten des ersten MOSFET-Halbleiterschalters T11 im Zeitpunkt t3 wird zum Zeitpunkt t3 Energie aus der zweiten Wicklung L2 über die zweite Freilaufdiode D6 auf den zweiten Ausgangskondensator C5 übertragen, weshalb der Strom I_{L2} durch die zweite Wicklung L2 in dem Zeitabschnitt T3 linear abnimmt (vgl. Diagramm nach Figur 2b). Gleichzeitig erhöht sich die Spannung an dem zweiten Ausgangskondensator C5 und damit auch die zweite Ausgangsspannung Out2, wodurch die Differenzspannung, also die Lastspannung U_{L} erhöht wird und ein entsprechender Strom I_{Last} als Stromfluss durch die Last L entsteht, wobei wiederum auch die Spannung an dem ersten Ausgangskondensator C3 damit auch die erste Ausgangsspannung Out1 erhöht wird (vgl. Diagramme nach Figur 2a) und Figur 2c).

Da sich sowohl die Spannung an dem zweiten Ausgangskondensator C5, die der zweiten Ausgangsspannung Out2 entspricht, als auch die Spannung an dem ersten Ausgangskondensator C3, die der ersten Ausgangsspannung Out1 entspricht, erhöht, ist die Differenz-Ripplespannung an der Last L sehr klein und wird im Wesentlichen durch den Kapazitätswert des Siebkondensators C4 bestimmt.

Da die Spannung an dem ersten Ausgangskondensator C3 größer ist als die Eingangsgleichspannung U_{B} an dem Eingangskondensator C1 ist, wird im nächsten Einschaltzeitpunkt t5 des ersten MOSFET-Halbleiterschalters T11 zunächst Energie aus dem ersten Ausgangskondensator C3 entnommen dadurch dessen Spannung und somit die erste Ausgangsspannung Out1 wieder reduziert. Durch diese Reduzierung der Spannung an dem ersten Ausgangskondensator C3 wird die Differenzspannung an der Last, also die Lastspannung U_{L} wieder erhöht, wodurch wieder ein Stromfluss durch die Last U initiiert und gleichzeitig auch die Spannung am zweiten Ausgangskondensator C5 damit auch die zweite Ausgangsspannung Out2 reduziert wird.

Durch diesen synchronen Effekt der Spannungsanhebung und Spannungsabsenkung weist die Ripplespannung auf der ersten Ausgangsspannung Out1 und die Ripplespannung der zweiten Ausgangsspannung Out2 einen ähnlichen Verlauf auf, wodurch die Ripplespannung der Lastspannung U_{L} sehr gering ist. Durch eine Erhöhung der Kapazität des Siebkondensators C4 kann die Ripplespannung weiter reduziert werden.

Da sowohl in der Einschaltphase des ersten MOSFET-Halbleiterschalters T11 über die Spannungsabsenkung an dem ersten Ausgangskondensator C3 als auch in der Ausschaltphase des ersten MOSFET-Halbleiterschalters T11 über die Spannungsanhebung an dem zweiten Ausgangskondensator C5 aktiv Energie an die Last L übertragen wird, ist nur eine geringe Energie in den Ausgangskondensatoren C3 und C5 zu speichern. Daher können die Kapazitätswerte dieser Ausgangskondensatoren C3 und C5 klein gewählt werden.

Soll die Lastspannung U_{L} abgesenkt werden, so wird das zweite Schaltelement T2, also der MOSFET-Halbleiterschalter T11 eingeschaltet um Energie aus dem zweiten Ausgangskondensator C5 in das Magnetfeld des Übertragers Tr einzuspeisen, wodurch die Spannung an diesem zweiten Ausgangskondensator C5 bis zur Höhe der Eingangsgleichspannung U_{B} reduziert wird. Anschließend wird die Energie aus der Eingangsgleichspannungsquelle E entnommen. Solange der MOSFET-Halbleiterschalter T11 eingeschaltet ist, erhöht sich die Energie, die im Übertrager Tr gespeichert wird.

Mit dem Ausschalten des zweiten MOSFET-Halbleiterschalters T21 wird die gespeicherte Energie aus der ersten Wicklung L1 über die erste Freilaufdiode D5 an den ersten Ausgangskondensator C3 übertragen, wodurch dessen Spannung und damit auch die zweite Ausgangsspannung Out2 erhöht wird. Hierdurch entsteht ein Stromfluss durch die Last L, wodurch die Spannung an dem zweiten Ausgangskondensator C5, d. h. die zweite Ausgangsspannung Out2 erhöht wird.

Da die Spannungserhöhung gleichzeitig an dem ersten und zweiten Ausgangskondensator C3 und C5 erfolgt, ist die Ripplespannung an der Last L sehr klein. Die Ripplespannung kann durch eine Erhöhung der Kapazität des Siebkondensators weiter reduziert werden.

Da sowohl in der Einschaltphase des zweiten MOSFET-Halbleiterschalters T21, also in der Energiespeicherphase, als auch in der Ausschaltphase des zweiten MOSFET-Halbleiterschalters, also in der Energieabgabephase, aktiv Strom durch die Last L geführt wird, können die Kapazitäten der Ausgangskondensatoren C3 und C5 klein gewählt werden.

Dadurch dass die Lastspannung U_{L} als Ausgangsspannung durch die Differenz von der ersten Ausgangsspannung Out1 und der zweiten Ausgangsspannung Out2 gebildet wird, lässt sich in einfacher Weise eine positive Lastspannung U_{L} erzeugen, wenn die zweite Ausgangsspannung Out2 größer als die erste Ausgangsspannung Out1 ist oder eine negative Lastspannung U_{L}, wenn die erste Ausgangsspannung Out1 größer als die zweite Ausgangsspannung Out2 ist. Gleichzeitig lassen sich beliebig kleine Lastspannungen erzeugen. Damit ist es bspw. möglich, eine beliebige Ausgangsspannung derart zu erzeugen, wie es zum Ansteuern eines Sinusgenerators, zum Ansteuern von Elektromotoren oder zum Einspeisen in ein Netzsystem erforderlich ist. Ferner ist damit die Möglichkeit gegeben, auch ein Audiosignal zum Ansteuern von Lautsprechern zu erzeugen.

Durch die Möglichkeit, die Lastspannung U_{L} aktiv anzuheben und aktiv abzusenken, kann dieses Schaltnetzteil 1 gemäß Figur 1 auch als Spannungsregler eingesetzt werden, die Lastspannung U_{L} zu stabilisieren.

Ist als Last L ein Elektromotor angeschlossen, so kann über das erste und zweite Ausgangsgleichrichtelement D3 und D4 eine Rekuperation stattfinden, indem der Rekuperationskondensator C2 geladen wird.

Im normalen Betrieb des Schaltnetzteils 1 wird der Rekuperationskondensator C2 auf die höchste vorkommende Spannung der ersten und zweiten Ausgangsspannung Out1 und Out2 geladen. Im Falle einer Rekuperation wird über das Ausgangsgleichrichtelement D3 oder D4 die Spannung an dem Rekuperationskondensator C2 erhöht, d. h. die zurückgewonnene Energie diesem Rekuperationskondensator C2 gespeichert. Diese Erhöhung der Spannung an dem Rekuperationskondensator C4 kann detektiert werden und über den Tiefsteller T an die Eingangsgleichspannungsquelle E zurückgeführt werden.

Anstelle der Freilaufdioden D5 und D6 der beiden Schaltmittel T1 und T2 können auch die in den MOSFET-Halbleiterschaltern T11 und T21 enthaltenen Bodydioden benutzt werden. Da diese Bodydioden eine geringe Effizienz aufweisen, können die beiden MOSFET-Halbleiterschalter T11 und T21 als Synchron-MOSFET gegenphasig getaktet werden, so dass auf die Freilaufdioden D5 und D6 als externe Dioden verzichtet werden kann.

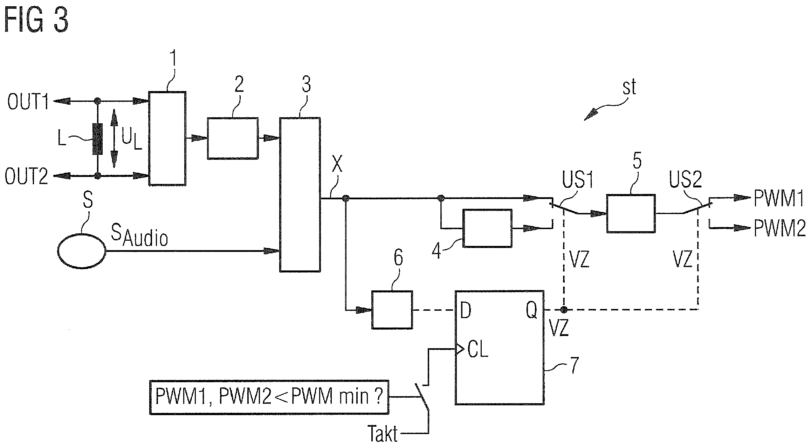

Wird das Schaltnetzteil 1 nach Figur 1 als Audioverstärker eingesetzt, ist es erforderlich, eine verzerrungsfreie Regelung zu erzeugen. Hierzu ist erforderlich, dass das Vorzeichen der Regelung in einem optimalen Zeitpunkt umgeschaltet wird. Der optimale Zeitpunkt der Vorzeichen-Umschaltung liegt genau dort, wo die Pulsbreite des gerade aktiven PWM-Signals, also jenes, welches gerade an dem ersten oder zweiten Schaltmittel T1 oder T2 anliegt kleiner als eine minimale Pulsbreite PWMₘᵢₙ ist. Diese minimale Pulsbreite PWMₘᵢₙ wird möglichst so klein gewählt, dass dieser Wert noch detektierbar ist. Welches der beiden PWM-Signale, also das erste PWM-Signal PWM1 oder das zweite PWM-Signal PWM2 gerade aktiv ist, wird durch ein Vorzeichensignal VZ bestimmt, deren Funktion weiter unten im Zusammenhang mit Figur 3 erläutert wird.

Daraus ergeben sich folgende Vorteile:
- minimaler Regelungsfehler im Schaltmoment, da durch die kleinste Pulsbreite des PWM-Signals PWM1 und PWM2 wenig Energie übertragen wird,
- optimale Energiebilanz, da bis zum Zeitpunkt der Vorzeichen-Umschaltung die Energie ausschließlich in der Last L verbraucht wird,
- der aktive Spannungsabbau führt zu erhöhter Dynamik, da der geforderte Spannungsabbau nicht nur passiv durch die Last geschieht, sondern aktiv durch den Übertrager Tr unterstützt wird. Dadurch erfolgt sowohl der Spannungsaufbau als auch der Spannungsabbau kontrolliert durch das Schaltnetzteil 1.

Eine solche Regelung zur Realisierung des optimalen Umschaltzeitpunktes wird nachfolgend anhand des Blockschaltbildes einer Steuerschaltung St nach Figur 3 erläutert.

Hierzu werden mittels der Steuerschaltung St in Abhängigkeit des von einer Signalquelle S erzeugten analogen Audiosignals S_{Audio} und den beiden Ausgangsspannungen Out1 und Out2 die beiden PWM-Signale PWM1 und PWM2 erzeugt, so dass entweder das erste PWM-Signal PWM1 an das erste Schaltmittel T1 oder das zweite PWM-Signal PWM2 an das zweite Schaltmittel T2 angelegt wird. Damit stellt diese Steuerschaltung St eine Regelschaltung zur Regelung des Tastverhältnisses der beiden PWM-Signale PWM1 und PWM2 in Abhängigkeit des Audiosignals S_{Audio} dar. Mit dem das erste Schaltmittel T1 steuernden ersten PWM-Signal PWM1 wird über dessen Pulsbreite der Wert einer positiven Spannung an der Last L geregelt, während mit dem das zweite Schaltmittel T2 steuernden zweiten PWM-Signal PWM1 über dessen Pulsbreite der Wert einer negativen Spannung an der Last L geregelt wird.

Als Führungsgröße dieser Regelung dient die Differenz zwischen der ersten und zweiten Ausgangsspannung Out1 und Out2, die als verstärktes Ausgangssignal an der Last L anliegt. Zur Bildung der an der Last L anliegenden Differenzspannung wird die Lastspannung U_{L} einer Differenzschaltung 1 zugeführt und anschließend mittels einer Signalabschwächungsschaltung 2 um den Verstärkungsfaktor des Schaltnetzteils 1 abgeschwächt. Dieses derart erzeugte Differenzsignal wird einer weiteren Differenzschaltung 3 zugeführt, welches das Differenzsignal mit dem Audiosignal S_{Audio} vergleicht.

Die Differenz zwischen dem Differenzsignal als abgeschwächtes Ausgangssignal und dem Audiosignal S_{Audio} stellt das zu regelnde Regelsignal x dar. Dieses Regelsignal x wird zur Erzeugung des ersten PWM-Signals PWM1 verwendet. Durch einen Invertierer 4 wird das Regelsignal x invertiert und zur Erzeugung des zweiten Regel-Signals PWM2 verwendet. Abhängig von einem Vorzeichensignal VZ wird mittels eines ersten Umschalters US1 und eines zweiten Umschalters US2 sowie eines PWM-Generators 5 nur ein PWM-Signal erzeugt, nämlich entweder nur das erste PWM-Signal PWM1 oder das zweite PWM-Signal PWM2.

Gleichzeitig wird das Regelsignal x hinsichtlich seiner Polarität-Richtung mittels eines Komparators 6 detektiert, auf das Regelsignal x größer oder kleiner Null ist. Diese Richtungsinformation wird einem D-Eingang eines Flipflops 7, welches als taktflankengesteuertes D-Flipflop ausgeführt ist, bereitgestellt. Am Q-Ausgang des Flipflops 7 liegt das Vorzeichensignal VZ an, mit welchem die beiden Umschalter US1 und US2 gesteuert werden.

Dieses Vorzeichensignal VZ bestimmt, ob entweder das erste PWM-Signal PWM1 erzeugt, also aktiv ist und dem ersten Schaltmittel T1 zugeführt wird oder ob das zweite PWM-Signal PWM2 erzeugt, also aktiv ist und dem zweiten Schaltmittel T2 zugeführt wird. Sobald die Pulsbreite des aktiven PWM-Signals kleiner als die vorgegebene minimale Pulsbreite PWMₘᵢₙ ist, übernimmt das Flipflop 7 die Richtungsinformation als die neue Vorzeicheninformation des Regelsignals x, indem ein hochfrequenter Takt an den Cl-Eingang des Flipflops 7 geschaltet wird. Das neue Vorzeichensignal VZ aktiviert damit das neue PWM-Signal entsprechend.

Die Regelung wird folgendermaßen durchgeführt:
Soll der Betrag der Lastspannung U_{L} (die entweder positiv oder negativ ist) erhöht werden, so wird die Pulsbreite des gerade aktiven PWM-Signals (entweder PWM1 oder PWM2) vergrößert und damit mehr Energie einem der beiden Ausgangskondensatoren C3 und C5 und damit einem der beiden Ausgänge Out1 und Out2 zugeführt. Soll der Betrag der Lastspannung U_{L} verkleinert werden, so wird die Pulsbreite des gerade aktiven PWM-Signals verkleinert und damit weniger Energie einem der beiden Ausgangskondensatoren C3 und C5 damit einem der beiden Ausgänge Out1 und Out2 zugeführt. Die Reduzierung der Lastspannung U_{L} erfolgt in dieser zuletzt angeführten Phase passiv, da die Reduzierung der Spannung nur aufgrund des Energieverbrauchs durch die Last L erfolgt. Solange die Pulsbreite des gerade aktiven PWM-Signals größer als die minimale Pulsbreite PWMₘᵢₙ ist, erfolgt die Reduzierung des Betrages der Lastspannung U_{L} nur passiv durch die Last L.

Durch die Reduzierung der Lastspannung U_{L} wird auch die von dem Vorzeichensignal VZ übernommene Richtungsinformation des Regelsignals x geändert. Diese Änderung der Richtungsinformation bleibt jedoch so lange ohne Auswirkungen, solange die Pulsbreite des gerade aktiven PWM-Signals größer als die minimale Pulsbreite PWMₘᵢₙ ist. Erst wenn die aktuelle Pulsbreite auf den Wert der minimalen Pulsbreite PWMₘᵢₙ abgenommen hat, wird das Flipflop 7 am Cl-Eingang mit einem hochfrequenten Takt getriggert, wodurch das Vorzeichensignal VZ die neue Richtungsinformation übernimmt. Dadurch wird die PWM-Ansteuerung der beiden Mittel T1 T2 aufgrund des Vorzeichenwechsels geändert d. h. war bisher das erste PWM-Signal PWM1 aktiv, wird jetzt das zweite PWM-Signal PWM2 aktiv (und umgekehrt). Mit dem nunmehr aktiven PWM-Signal wird die Lastspannung U_{L} weiter aktiv reduziert. Außerdem ist die Übernahmeverzerrung durch das Umschalten in diesem Fall klein, da im Umschaltmoment durch die kleine PWM-Pulsbreite nur wenig Energie in die Last L transferiert wird.

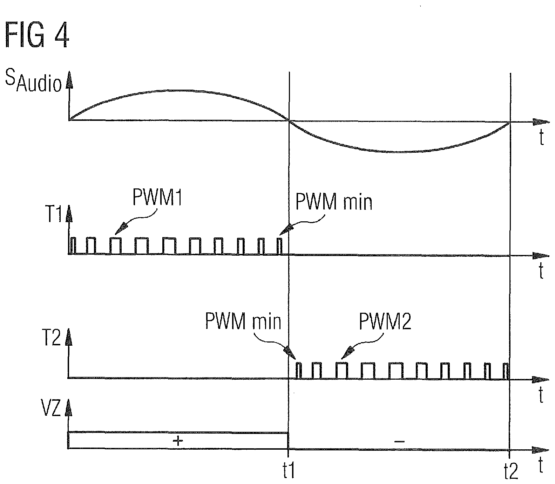

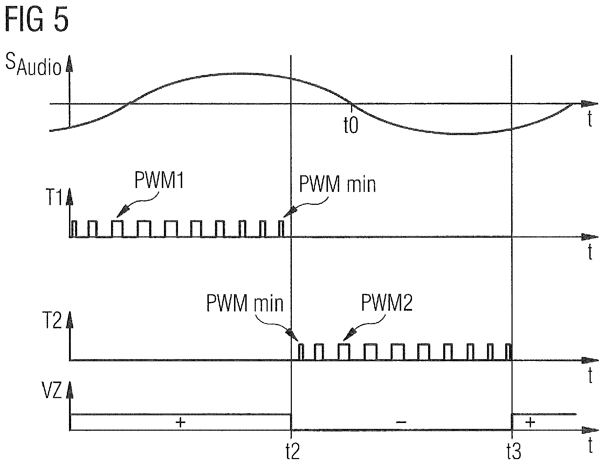

Im Folgenden wird die Erzeugung von PWM-Signalen PWM1 und PWM2 anhand der Zeit-PWM-Signal-Diagramme gemäß den Figuren 4 und 5 erläutert. Hierbei betrifft Figur 4 den Fall, wonach PWM-Signale bei großer Last L (d. h. niederohmig ist), also bei einem großen Laststrom erzeugt werden. Die Figur 5 betrifft den Fall, wonach PWM-Signale bei kleiner Last L (d. h. hochohmig), also bei einem kleinen Laststrom erzeugt werden. Um eine sehr große Dynamik zu erhalten, wird die lückende Betriebsart des Schaltnetzteils 1 gemäß Figur 1 gewählt.

Durch die lückende Betriebsart wird der Übertrager Tr ständig komplett entmagnetisiert, so dass sich das System schnell auf die neuen Anforderungen (viel oder wenig Energiebedarf) einstellen kann. Wäre der Übertrager Tr vollständig magnetisiert, so wäre er nicht in der Lage, sich auf eine Anforderung mit nur wenig Energiebedarf einzustellen, denn erst muss er entladen, d. h. entmagnetisiert werden. Die lückende Betriebsart wird daran erkannt, dass der Spulenstrom I_{L1} oder I_{L2} der ersten Wicklung L1 oder der zweiten Wicklung L2 nach jeder Energieabgabe den Wert Null erreicht (vgl. Zeitabschnitt T3 des Diagramms nach Figur 2b)).

Neben dem Verlauf des Audiosignals S_{Audio} ist in Figur 4 auch der Verlauf des ersten PWM-Signals PWM1, welches dem ersten Schaltelement T1 zugeführt wird, der Verlauf des zweiten PWM-Signals PWM2, welches dem zweiten Schaltelement T2 zugeführt wird und der Verlauf des Vorzeichensignals VZ dargestellt. Ferner ist in dem Zeit-PWMl-Diagramm und dem Zeit-PWM2-Diagramm derjenige Impuls gekennzeichnet, welcher kleiner als die minimale Pulsbreite PWMₘᵢₙ ist.

Weiterhin ist in Figur 4 der Umschaltzeitpunkt mit t₁ gekennzeichnet, wobei bis zu diesem Umschaltzeitpunkt t₁ das Vorzeichensignal VZ positiv und danach negativ ist. In diesem Zeitpunkt t₁ wechselt das Audiosignal S_{Audio} von einer positiven Halbwelle in eine negative Halbwelle.

Im Umschaltzeitpunkt t₁ des Vorzeichensignals VZ ist die PWM-Pulsbreite des PWM-Signals PWM1 sehr klein, auch nach der Umschaltung ist die PWM-Pulsbreite des PWM-Signals PWM2 zunächst sehr klein. Damit ist die Übernahmeverzerrung durch das Umschalten ebenso sehr klein. Die große Last L bewirkt nun die Absenkung der Lastspannung U_{L}, so dass erst bei tiefer Lastspannung U_{L} die PWM-Pulsbreite kleiner wird und deshalb die Umschaltung des Vorzeichens erfolgt.

Auch die Figur 5 zeigt neben dem Verlauf des Audiosignals S_{Audio} ebenso den Verlauf des ersten PWM-Signals PWM1, welches dem ersten Schaltelement T1 zugeführt wird, den Verlauf des zweiten PWM-Signals PWM2, welches dem zweiten Schaltelement T2 zugeführt wird und den Verlauf des Vorzeichensignals VZ. Ferner ist in dem Zeit-PWMl-Diagramm und dem Zeit-PWM2-Diagramm derjenige Impuls gekennzeichnet, welcher kleiner als die minimale Pulsbreite PWMₘᵢₙ ist.

Weiterhin sind in Figur 5 Umschaltzeitpunkte t₂ und t₃ dargestellt, die nicht mit dem Zeitpunkt to des Audiosignals S_{Audio} zusammenfällt, in welchem die Halbwellen das Vorzeichen wechseln. Im Umschaltzeitpunkt t₂ wechselt das Vorzeichensignal VZ von positiv nach negativ und im Umschaltzeitpunkt t₃ von negativ nach positiv.

Es wird angenommen, dass die Last L nur einen kleinen Laststrom aufnimmt, also hochohmig ist und ein lückender Betrieb des Schaltnetzteils 1 durchgeführt wird.

Im Umschaltzeitpunkt t₂ des Vorzeichensignals VZ ist die PWM-Pulsbreite des PWM-Signals PWM1 sehr klein, auch nach der Umschaltung ist die PWM-Pulsbreite des PWM-Signals PWM2 zunächst sehr klein. Damit ist die Übernahmeverzerrung durch das Umschalten ebenso sehr klein. Die kleine Last L bewirkt keine Absenkung der Lastspannung U_{L}, so dass rechtzeitig, d. h. bei einem noch großen Spannungswert der Ausgangsspannung Out1 oder Out2 die PWM-Pulsbreite des PWM-Impulses PWM2 kleiner wird und deshalb die Umschaltung des Vorzeichens erfolgt. Damit fallen die Zeitpunkte to des Audiosignals S_{Audio} nicht mit den Umschaltzeitpunkten t₂ und t₃ zusammen. Durch den Vorzeichenwechsel wird aktiv Energie aus dem Ausgang mit der größeren Ausgangsspannung Out1 oder Out2 entnommen und diese Energie dem Ausgang mit der kleineren Ausgangsspannung zugeführt. Daher wird in diesem Umschaltzeitpunkten t₂ und t₃ aktiv entladen und somit die passive Entladung durch die Last L unterstützt. Dies führt außerdem zu einer starken Erhöhung der Dynamik des Systems.

Die mit der Schaltung nach Figur 3 durchgeführte Regelung des Schaltnetzteils 1 nach Figur 1 zeichnet sich also dadurch aus, dass die Umschaltzeitpunkte, also der mit dem Vorzeichensignal VZ angezeigte Vorzeichenwechsel in Abhängigkeit von der Belastung der Lastspannung U_{L} durchgeführt wird. Mit dieser Regelung erfolgt immer dann ein Wechsel des Vorzeichens, wenn die PWM-Pulsbreite des gerade aktiven PWM-Signals klein, also kleiner als eine vorgegebene minimale Pulsbreite PWMₘᵢₙ ist. Dieses Verfahren ist bei jeder Art von Last durchführbar.

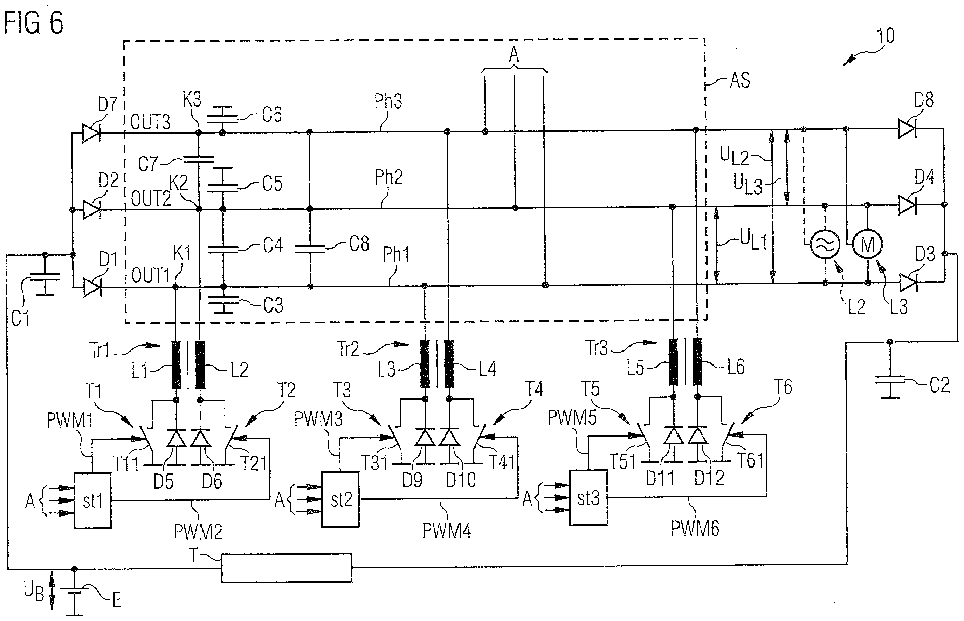

Das Schaltnetzteil 1 gemäß Figur 1 wird nur mit einer Phase betrieben. Es ist jedoch auch möglich, mit diesem Schaltnetzteil 1 ein Schaltnetzteil 10 zum Betreiben an 3 Phasen (erste Phase Ph1, zweite Phase Ph2, dritte Phase Ph3) aufzubauen, wie dies in Figur 6 dargestellt ist.

Bei diesem 3-Phasen-Schaltnetzteil 10 werden drei Übertrager verwendet, deren Aufbau dem Übertrager Tr gemäß Figur 1 entspricht.

Ein erster Übertrager Tr1 umfasst eine erste Wicklung L1 und eine zweite Wicklung L2, wobei die zweite Wicklung L2 gegensinnig zur ersten Wicklung L1 gewickelt ist.

Eine Reihenschaltung aus der ersten Wicklung L1 des ersten Übertragers Tr1 und einem ersten Schaltmittel T1 ist unter Bildung eines ersten Knotenpunktes K1 über ein als Diode ausgeführtes erstes Eingangsgleichrichtelement D1 an eine eine Eingangsgleichspannung U_{B} erzeugende Eingangsgleichspannungsquelle E angeschlossen. Der Knotenpunkt K1 bildet die erste Phase Ph1, an welchem die erste Ausgangsspannung Out1 abgreifbar ist.

Ferner ist eine weitere Reihenschaltung aus der zweiten Wicklung L2 des ersten Übertragers Tr1 und einem Schaltmittel T2 unter Bildung eines zweiten Knotenpunktes K2 über ein als Diode ausgeführtes zweitens Eingangsgleichrichtelement D2 ebenso an die Eingangsgleichspannungsquelle E angeschlossen. Der zweite Knotenpunkt K2 bildet die zweite Phase Ph2, an welchem die zweite Ausgangsspannung Out2 abgreifbar ist.

Die Differenz dieser beiden Ausgangsspannungen Out1 und Out2 liegt als Leiterspannung U_{L1} an der als 3-Phasen-Motor ausgeführten Last L1 an.

Das erste Schaltmittel T1 des ersten Übertragers Tr1 besteht aus einem ersten MOSFET-Halbleiterschalter T11 und einer ersten Freilaufdiode D5, die den ersten MOSFET-Halbleiterschalter T11 überbrückt. Das zweite Schaltmittel T2 des ersten Übertragers Tr1 besteht aus einem zweiten MOSFET-Halbleiterschalter T21 und einer zweiten Freilaufdiode D6, die den zweiten MOSFET-Halbleiterschalter T21 überbrückt. Die beiden Freilaufdioden D5 und D6 sind bzgl. der Eingangsgleichspannung U_{B} in Sperrrichtung geschaltet.

Ein zweiter Übertrager Tr2 umfasst eine erste Wicklung L3 und eine zweite Wicklung L4, wobei die zweite Wicklung L4 gegensinnig zur ersten Wicklung L3 gewickelt ist.

Eine Reihenschaltung aus der ersten Wicklung L3 und einem ersten Schaltmittel T3 ist mit dem ersten Knotenpunkt K1 verbunden.

Ferner ist eine weitere Reihenschaltung aus der zweiten Wicklung L4 und einem Schaltmittel T4 unter Bildung eines dritten Knotenpunktes K3 über ein als Diode ausgeführtes drittes Eingangsgleichrichtelement D7 ebenso an die Eingangsgleichspannungsquelle E angeschlossen. Der dritte Knotenpunkt K3 bildet die dritte Phase Ph3, an welchem die dritte Ausgangsspannung Out3 abgreifbar ist.

Das erste Schaltmittel T3 des zweiten Übertragers Tr2 besteht aus einem ersten MOSFET-Halbleiterschalter T31 und einer ersten Freilaufdiode D9, die den ersten MOSFET-Halbleiterschalter T31 überbrückt. Das zweite Schaltmittel T2 des zweiten Übertragers Tr2 besteht aus einem zweiten MOSFET-Halbleiterschalter T41 und einer zweiten Freilaufdiode D10, die den zweiten MOSFET-Halbleiterschalter T41 überbrückt. Die beiden Freilaufdioden D9 und D10 sind bzgl. der Eingangsgleichspannung U_{B} in Sperrrichtung geschaltet.

Die Differenz der beiden Ausgangsspannungen Out1 und Out3 liegt als Leiterspannung U_{L2} an der als 3-Phasen-Motor ausgeführten Last L1 an.

Ein dritter Übertrager Tr3 umfasst eine erste Wicklung L5 und eine zweite Wicklung L6, wobei die zweite Wicklung L6 gegensinnig zur ersten Wicklung L5 gewickelt ist.

Eine Reihenschaltung aus der ersten Wicklung L5 und einem ersten Schaltmittel T5 ist an den zweiten Knotenpunkt K2 angeschlossen.

Ferner ist eine weitere Reihenschaltung aus der zweiten Wicklung L6 und einem zweiten Schaltmittel T6 mit dem dritten Knotenpunkt K3 verbunden.

Das erste Schaltmittel T5 des dritten Übertragers Tr3 besteht aus einem ersten MOSFET-Halbleiterschalter T51 und einer ersten Freilaufdiode D11, die den ersten MOSFET-Halbleiterschalter T51 überbrückt. Das zweite Schaltmittel T6 des dritten Übertragers Tr3 besteht aus einem zweiten MOSFET-Halbleiterschalter T61 und einer zweiten Freilaufdiode D12, die den zweiten MOSFET-Halbleiterschalter T61 überbrückt. Die beiden Freilaufdioden D11 und D12 sind bzgl. der Eingangsgleichspannung U_{B} in Sperrrichtung geschaltet.

Die Differenz der beiden Ausgangsspannungen Out2 und Out3 liegt als Leiterspannung U_{L3} an der als 3-Phasen-Motor ausgeführten Last L1 an.

Die positive Eingangsgleichspannung U_{B} der Eingangsgleichspannungsquelle E ist an die Anoden der drei Eingangsgleichrichtelemente D1, D2 und D7 angeschlossen. Ferner ist an diesen Anoden der drei Eingangsgleichrichtelemente D1, D2 und D7 ein Eingangskondensator C1 gegen Masse angeschlossen.

Weiterhin ist der erste Knotenpunkt K1 mit einem bezüglich der Eingangsgleichspannung U_{B} in Durchlassrichtung geschalteten und als Diode ausgebildeten ersten Ausgangsgleichrichtelement D3 verbunden. Der zweite Knotenpunkt K2 ist mit einem bezüglich der Eingangsgleichspannung U_{B} in Durchlassrichtung geschalteten und ebenso als Diode ausgebildeten zweiten Ausgangsgleichrichtelement D4 verbunden. Schließlich ist der dritte Knotenpunkt K3 mit einem bezüglich der Eingangsgleichspannung U_{B} in Durchlassrichtung geschalteten und als Diode ausgebildeten dritten Ausgangsgleichrichtelement D8 verbunden. Die Kathoden dieser drei Ausgangsgleichrichtelemente D3, D4 und D8 sind zusammengeführt und mit einem Tiefsteller T verbunden, der seinerseits an die Eingangsgleichspannungsquelle E angeschlossen ist. Ferner sind die drei verbundenen Kathoden der Ausgangsgleichrichtelemente D3, D4 und D8 über einen Rekuperationskondensator C2 mit Masse verbunden. Diese drei Ausgangsgleichrichtelemente D3, D4 und D8 dienen zusammen mit dem Tiefsteller T der Energierückgewinnung, wie es im Zusammenhang mit dem Schaltnetzteil gemäß Figur 1 bereits erläutert wurde.

Die PWM-Signale zur Ansteuerung der Schaltelemente T1 bis T6 der drei Übertrager Tr1, Tr2 und Tr3 werden in Verbindung mit einer Ausgangsschaltung AS jeweils von einer Steuerschaltung St1, St2 und St3 erzeugt.

Die beiden PWM-Signale PWM1 und PWM2 werden von der ersten Steuerschaltung St1 erzeugt und jeweils dem Schaltmittel T1 und T2 zugeführt, wobei jeweils nur ein PWM-Signal aktiv ist.

Die beiden PWM-Signale PWM3 und PWM4 werden von der zweiten Steuerschaltung St2 erzeugt und jeweils dem Schaltmittel T3 und T4 zugeführt, wobei jeweils nur ein PWM-Signal aktiv ist.

Die beiden PWM-Signale PWM5 und PWM6 werden von der dritten Steuerschaltung St3 erzeugt und jeweils dem Schaltelement T5 und T6 zugeführt, wobei jeweils nur ein PWM-Signal aktiv ist.

Zur Erzeugung dieser PWM-Signale PWM1 bis PWM6 werden den Steuerschaltungen St1, St2 und St3 die erste, zweite und dritte Ausgangsspannung Out1, Out2 und Out3 zugeführt.

Die Ausgangsschaltung AS umfasst folgende Ausgangskondensatoren:
- einen ersten Ausgangskondensator C3, welcher mit dem ersten Knotenpunkt K1 gegen Masse verbunden ist,
- einen zweiten Ausgangskondensator C5, welcher mit dem zweiten Knotenpunkt K2 gegen Masse verbunden ist
- ein dritter Ausgangskondensator C4 als Siebkondensator, welcher die beiden Knotenpunkte K1 und K2 verbindet,
- ein vierter Ausgangskondensator C6, welcher mit dem dritten Knotenpunkt K3 gegen Masse verbunden ist,
- ein fünfter Ausgangskondensator C7 als Siebkondensator, welcher die beiden Knotenpunkte K2 und K3 verbindet, und
- ein sechste Ausgangskondensator C8 als Siebkondensator, welcher die beiden Knotenpunkte K1 und K3 verbindet.

Anstelle der Freilaufdioden D5, D6, D9, D10, D11 und D12 der Schaltmittel T1, T2, T3, T4, T5 und T6 können auch die in den MOSFET-Halbleiterschaltern T11, T21, T31, T41, T51 und T61 enthaltenen Bodydioden benutzt werden. Da diese Bodydioden eine geringe Effizienz aufweisen, können die beiden MOSFET-Halbleiterschalter der drei Übertrager Tr1, Tr2 und Tr3 jeweils als Synchron-MOSFET gegenphasig getaktet werden, so dass auf die Freilaufdioden als externe Dioden verzichtet werden kann.

Über den Tastgrad der Rechteckimpulse der PWM-Signale PWM1 bis PWM6 werden die Ausgangsspannungen Out1, Out2 und Out3 geregelt und deren Differenz der Last L als Lastspannung zugeführt.

Die Last L1 ist gemäß Figur 6 als 3-Phasen-Elektromotor ausgeführt, kann jedoch auch eine Netzeinspeisung als Last L2 darstellen.

Die drei Übertrager Tr1, Tr2 und Tr3 des 3-Phasen-Schaltnetzteils gemäß Figur 6 werden phasenversetzt um 120° angesteuert. Bei der Energiezuführung leitete zeitlich gesehen nur jeweils eine der drei Eingangsgleichrichtelemente D1, D2 oder D7, nämlich diejenige, die mit der geringsten Ausgangsspannung Out1, Out2 oder Out3 verbunden ist. Dies wiederholt sich natürlich zyklisch nach jeweils 120°.

Hierbei wird die Regelung jeder der drei Übertrager Tr1, Tr2 und Tr3 entsprechend der oben beschriebenen Regelung im Zusammenhang mit der Regelung des Schaltnetzteils gemäß Figur 1 mittels der Steuerschaltung St gemäß Figur 2 durchgeführt. Damit werden auch die Umschaltzeitpunkte bei jedem dieser drei Übertrager Tr1, Tr2 und Tr3 in Abhängigkeit von der Belastung der drei Strangspannungen U_{L1}, U_{L2} und U_{L3} durchgeführt und immer dann ein Wechsel des Vorzeichens durchgeführt, wenn die PWM-Pulsbreite auf jeder Phase Ph1, Ph2 und Ph3 klein, also kleiner als eine vorgegebene minimale Pulsbreite PWMₘᵢₙ ist.

## Patentansprüche

1. Schaltnetzteil (1) zur Erzeugung einer Lastspannung (U_{L}) aus der Differenz einer ersten und zweiten Ausgangsspannung (Out1, Out2), wobei das Schaltnetzteil (1)an eine eine Eingangsgleichspannung (U_{B}) bereitstellende Eingangsgleichspannungsquelle (E) anschließbar ist, und wobei das Schaltnetzteil (1) folgende Komponenten umfasst:
- einen Übertrager (Tr) mit einer ersten Wicklung (L1), welche in Serie mit einem ersten getakteten Schaltmittel (T1) geschaltet ist und einer zweiten Wicklung (L2), welche in Serie mit einem zweiten getakteten Schaltmittel (T2) geschaltet ist,
- ein mit der ersten Wicklung (L1) verbundener erster Ausgangskondensator (C3), an welchem die erste Ausgangsspannung (Out1) abgreifbar ist,
- ein mit der zweiten Wicklung (L2) verbundener zweiter Ausgangskondensator (C5), an welchem die zweite Ausgangsspannung (Out2) abgreifbar ist,
- eine Steuerschaltung (St), welche mit dem ersten und dem zweiten getakteten Schaltmittel (T1, T2) verbunden ist,
**dadurch gekennzeichnet, dass** die Steuerschaltung (St) derart ausgebildet ist, dass entweder
- zur Erhöhung der Lastspannung (U_{L}) in einer Einschaltphase des ersten getakteten Schaltmittels (T1) Energie aus dem ersten Ausgangskondensator (C3) und aus der Eingangsgleichspannungsquelle (E) in dem Übertrager (Tr) speicherbar ist und in einer Ausschaltphase die gespeicherte Energie auf den zweiten Ausgangskondensator (C5) übertragbar ist, oder
- zur Erniedrigung der Lastspannung (U_{L}) in einer Einschaltphase des zweiten getakteten Schaltmittels (T2) Energie aus dem zweiten Ausgangskondensator (C5) und aus der Eingangsgleichspannungsquelle (E) in dem Übertrager (Tr) speicherbar ist und in einer Ausschaltphase die gespeicherte Energie auf den ersten Ausgangskondensator (C3) übertragbar ist, und wobei das Schaltnetzteil (1) weiterhin umfasst
- ein bezüglich der Eingangsgleichspannung (U_{B}) in Durchlassrichtung geschaltetes erstes Eingangsgleichrichtelement (D1), welches mit der ersten Wicklung (L1) verbunden ist, und
- ein bezüglich der Eingangsgleichspannung (U_{B}) in Durchlassrichtung geschaltetes zweites Eingangsgleichrichtelement (D2), welches mit der zweiten Wicklung (L2) verbunden ist.

2. Schaltnetzteil (1) nach Anspruch 1, bei welchem
- das erste Schaltmittel (T1) einen ersten Halbleiterschalter (T11) und eine erste Freilaufdiode (D5) umfasst, und
- das zweite Schaltmittel (T2) einen zweiten Halbleiterschalter (T21) und eine zweite Freilaufdiode (D6) umfasst.

3. Schaltnetzteil (1) nach Anspruch 1, bei welchem
- das erste Schaltmittel (T1) einen ersten MOSFET-Halbleiterschalter (T11) umfasst, und
- das zweite Schaltmittel (T1) einen zweiten MOSFET-Halbleiterschalter (T21) umfasst.

4. Schaltnetzteil (1) nach Anspruch 3, bei welchem der erste und zweite MOSFET-Halbleiterschalter als Synchron-MOSFET gegenphasig taktbar sind.

5. Schaltnetzteil (1) nach einem der vorhergehenden Ansprüche, bei welchem
- ein erstes Ausgangsgleichrichtelement (D3) bezüglich der Eingangsgleichspannung (U_{B}) in Durchlassrichtung mit dem ersten Ausgangskondensator (C3) verbunden ist,
- ein zweites Ausgangsgleichrichtelement (D4) bezüglich der Eingangsgleichspannung (U_{B}) in Durchlassrichtung mit dem zweiten Ausgangskondensator (C5) verbunden ist, und
- ein Rekuperationskondensator (C2) zur Energierückgewinnung mit dem ersten und zweiten Ausgangsgleichrichtelement (D3, D4) verbunden ist.

6. Schaltnetzteil (1) nach Anspruch 5, bei welchem zur Energierückführung ein den Rekuperationskondensator (C2) mit der Eingangsgleichspannungsquelle (U_{B}) verbindender Tiefsteller (T) vorgesehen ist.

7. Schaltnetzteil (1) nach einem der vorhergehenden Ansprüche mit einem Siebkondensator (C4), welcher den ersten Ausgangskondensator (C3) mit dem zweiten Ausgangskondensator (C5) verbindet.

8. Verwendung des Schaltnetzteils (1) nach einem der vorhergehenden Ansprüche für ein 3-Phasen-Schaltnetzteil (10) zur Erzeugung einer 3-Phasen-Lastspannung (U_{L1}, U_{L2}, U_{L3}) aus einer ersten, zweiten und dritten Ausgangsspannung (Out1, Out2, Out3) mittels eines ersten Übertragers (Tr1), eines zweiten Übertragers (Tr2) und eines dritten Übertragers (Tr3) mit einem ersten Ausgangskondensator (C3), an welchem die erste Ausgangsspannung (Out1) abgreifbar ist, mit einem zweiten Ausgangskondensator (C5), an welchem die zweite Ausgangsspannung (Out2) abgreifbar ist, und mit einem dritten Ausgangskondensator (C6), an welchem die dritte Ausgangsspannung (Out3) abgreifbar ist.

9. Verfahren zum Betreiben eines nach einem der der Ansprüche 1 bis 7 ausgebildeten Schaltnetzteils (1) als Verstärker mit einem Verstärkungsfaktor, indem
a) ein von einer Signalquelle (S) erzeugtes Eingangssignal (S_{Audio}) bereitgestellt wird,
b) eine Differenz zwischen der um den Verstärkungsfaktor verminderten Lastspannung (U_{L}) und dem Eingangssignal (S_{Audio}) als Regelsignal (x) gebildet wird,
c) aus dem Regelsignal (x) ein Vorzeichensignal (VZ) als Richtungsinformation des Regelsignals (x) erzeugt wird,
d) in Abhängigkeit des Regelsignals (x) ein erstes PWM-Signal (PWM1) und ein zweites PWM-Signal (PWM2) erzeugt werden,
e) in Abhängigkeit des Vorzeichensignals (VZ) das erste PWM-Signal (PWM1) an das erste Schaltmittel (T1) oder das zweite PWM-Signal (PWM2) an das zweite Schaltmittel (T2) angelegt wird,
f) bei einer PWM-Pulsbreite entweder des an dem ersten Schaltmittel (T1) anliegenden ersten PWM-Signals (PWM1) oder des an dem zweiten Schaltmittel (T2) anliegenden zweiten PWM-Signals (PWM2) kleiner als eine minimale Pulsbreite (PWMₘᵢₙ) in Abhängigkeit der von dem Vorzeichensignal (VZ) angezeigten Richtungsinformation des Regelsignals (x) entweder das zweite PWM-Signal (PWM2) an das zweite Schaltmittel (T2) oder das erste PWM-Signal (PWM1) an das erste Schaltmittel (T1) angelegt wird.

## Claims

1. Switching power supply (1) for generating a load voltage (U_{L}) from the difference between a first and a second output voltage (Out1, Out2), wherein the switching power supply (1) can be connected to an input DC voltage source (E) which provides an input DC voltage (U_{B}), and wherein the switching power supply (1) comprises the following components:
- a transducer (Tr), having a first winding (L1), which is connected in series to a first clocked switch means (T1), and having a second winding (L2), which is connected in series to a second clocked switch means (T2),
- a first output capacitor (C3) which is connected to the first winding (L1) and from which the first output voltage (Out1) can be tapped off,
- a second output capacitor (C5) which is connected to the second winding (L2) and from which the second output voltage (Out2) can be tapped off,
- a control circuit (St) which is connected to the first and second clocked switch means (T1, T2),
**characterized in that** the control circuit (St) is implemented such that either,
- in order to increase the load voltage (U_{L}), during a switch on phase of the first clocked switch means (T1), energy from the first output capacitor (C3) and from the input DC voltage source (E) can be stored in the transducer (Tr) and, during a switch off phase, the stored energy can be transferred to the second output capacitor (C5), or
- in order to reduce the load voltage (U_{L}), during a switch on phase of the second clocked switch means (T2), energy from the second output capacitor (C5) and from the input DC voltage source (E) can be stored in the transducer (Tr) and, during a switch off phase, the stored energy can be transferred to the first output capacitor (C3), and whereby the switching power supply (1) further comprises
- a first input rectifying element (D1), connected in the forward direction with respect to the input DC voltage source (U_{B}), which is connected to the first winding (L1), and
- a second input rectifying element (D2), connected in the forward direction with respect to the input DC voltage (U_{B}), which is connected to the second winding (L2).

2. Switching power supply (1) in accordance with claim 1, in which
- the first switch means (T1) comprises a first semiconductor switch (T11) and a first freewheeling diode (D5), and
- the second switch means (T2) comprises a second semiconductor switch (T21) and a second freewheeling diode (D6).

3. Switching power supply (1) in accordance with claim 1, in which
- the first switch means (T1) comprises a first MOSFET semiconductor switch (T11), and
- the second switch means (T2) comprises a second MOSFET semiconductor switch (T21).

4. Switching power supply (1) in accordance with claim 3, in which the first and the second MOSFET semiconductor switches can be clocked in phase opposition as synchronous MOSFETs.

5. Switching power supply (1) in accordance with any of the preceding claims, in which
- a first output rectifying element (D3) is connected, in the forward direction with respect to the input DC voltage (U_{B}), to the first output capacitor (C3),
- a second output rectifying element (D4) is connected, in the forward direction with respect to the input DC voltage (U_{B}), to the second output capacitor (C5), and
- a recuperation capacitor (C2) for energy recovery is connected to the first and second output rectifying elements (D3, D4).

6. Switching power supply (1) in accordance with claim 5, in which, for energy recovery, a step down converter (T) is provided which connects the recuperation capacitor (C2) to the input DC voltage source (E).

7. Switching power supply (1) in accordance with any of the preceding claims with a filter capacitor (C4) which connects the first output capacitor (C3) to the second output capacitor (C5).

8. Use of the switching power supply (1) in accordance with any of the preceding claims for a 3-phase switching power supply (10) for generating a 3-phase load voltage (U_{L1}, U_{L2}, U_{L3}), out of a first, second and third output voltage (Out1, Out2, Out3) by means of a first transducer (Tr1), a second transducer (Tr2) and a third transducer (Tr3), with a first output capacitor (C3), from which the first output voltage (Out1) can be tapped off, with a second output capacitor (C5), from which the second output voltage (Out2) can be tapped off, and with a third output capacitor (C6), from which the third output voltage (Out3) can be tapped off.

9. Method for operating a switching power supply (1) implemented in accordance with any of claims 1 to 7 as an amplifier with an amplification factor by
a) providing an input signal (S_{Audio}) generated by a signal source (S),
b) using a difference between the load voltage (UL), reduced by the amplification factor, and the input signal (SAudio) to create a control signal (x),
c) generating, from the control signal (x), a sign signal (VZ) as directional information for the control signal (x),
d) generating, in dependency on the control signal (x), a first PWM signal (PWM1) and a second PWM signal (PWM2),
e) applying, in dependency on the sign signal (VZ), the first PWM signal (PWM1) to the first switch means (T1) or the second PWM signal (PWM2) to the second switch means (T2),
f) when a PWM pulse width, either of the first PWM signal (PWM1), applied to the first switch means (T1), or of the second PWM signal (PWM2), applied to the second switch means (T2), is smaller than a minimum pulse width (PWMₘᵢₙ), applying, in dependency on the directional information for the control signal (x) given by the sign signal (VZ), either the second PWM signal (PWM2) to the second switch means (T2) or the first PWM signal (PWM1) to the first switch means (T1).

## Revendications

1. Alimentation à découpage (1) pour générer une tension de charge (U_{L}) à partir de la différence d'une première et d'une seconde tension de sortie (Out1, Out2),
- l'alimentation à découpage (1) étant reliée à une source de tension continue (E) fournissant une tension d'entrée (U_{B}), et
- l'alimentation à découpage (1) comprenant les composants suivants :
- un transformateur (Tr) avec un premier enroulement (L1) en série avec un moyen de commutation cadencé (T1) et un second enroulement (L2) en série avec un second moyen de commutation cadencé (T2),
- un premier condensateur de sortie (C3) relié au premier enroulement (L1) et qui fournit la première tension de sortie (Out1),
- un second condensateur de sortie (C5) relié au second enroulement (L2) et qui fournit la seconde tension de sortie (Out2),
- un circuit de commande (St) relié au premier et au second moyen de commutation cadencé (T1, T2),
alimentation **caractérisée en ce que**
- le circuit de commande (St) est réalisé de façon que :
* pour augmenter la tension de charge (U_{L}) dans une première phase de branchement du premier moyen de commutation cadencé (T1), l'énergie du premier condensateur de sortie (C3) et de la source de tension continue d'entrée (E) est accumulée dans le transformateur (Tr), et dans une phase de coupure, l'énergie accumulée est transmise au second condensateur de sortie (C5), ou
* pour abaisser la tension de charge (U_{L}) dans la première phase de branchement du second moyen de commutation cadencé (T2), l'énergie du second condensateur de sortie (C5) et de la source de tension continue d'entrée (E) est accumulée dans le transformateur (Tr) et dans une phase de coupure, l'énergie accumulée est transmise au premier condensateur de sortie (C3), et
- l'alimentation à découpage (1) comprend en outre :
* un premier élément redresseur d'entrée (D1) branché dans le sens passant par rapport à la tension d'entrée continue (U_{B}), et qui est relié au premier enroulement (L1), et
* un second élément redresseur d'entrée (D2) branché dans le sens passant par rapport à la première tension continue d'entrée (U_{B}) et qui est relié au second enroulement (L2).

2. Alimentation à découpage (1) selon la revendication 1,
dans laquelle :
- le premier moyen de commutation (T1) comprend un premier commutateur semi-conducteur (T11) et une première diode de roue libre (D5), et
- le second moyen de commutation (T2) comprend un second commutateur à semi-conducteur (T21) et une seconde diode de roue libre (D6).

3. Alimentation à découpage (1) selon la revendication 1,
dans laquelle :
- le premier moyen de commutation (T1) comprend un premier semi-conducteur MOSFET (T11), et
- le second moyen de commutation (T2) comprend un second semi-conducteur MOSFET (T21).

4. Alimentation à découpage (1) selon la revendication 3,
dans laquelle :
- le premier et le second semi-conducteurs MOSFET sont commandés en cadence, en opposition de phase en MOSFET synchrones.

5. Alimentation à découpage (1) selon l'une des revendications précédentes,
dans laquelle :
- un premier élément redresseur de sortie (D3) est relié par rapport à la tension continue d'entrée (U_{B}) dans le sens passant avec le premier condensateur de sortie (C3),
- un second élément redresseur de sortie (D4) est relié par rapport à la tension continue d'entrée (U_{B}) dans le sens passant avec le second condensateur de sortie (C5), et
- un condensateur de récupération (C2) est relié au premier et au second élément redresseur de sortie (D3, D4) pour récupérer l'énergie.

6. Alimentation à découpage (1) selon la revendication 5,
dans laquelle
pour récupérer l'énergie, un convertisseur buck (T) est prévu pour relier le condensateur de récupération (C2) à la source de tension continue d'entrée (U_{B}) pour récupérer l'énergie.

7. Alimentation à découpage (1) selon l'une des revendications précédentes,
comprenant un condensateur filtre (C4) reliant le premier condensateur de sortie (C3) au second condensateur de sortie (C5).

8. Application de l'alimentation à découpage (1) selon l'une des revendications précédentes à une alimentation à découpage triphasée (10) pour générer une tension de charge triphasée (U_{L1}, U_{L2}, U_{L3}) à partir d'une première, d'une seconde et d'une troisième tension de sortie (Out1, Out2, Out3) à l'aide d'un premier transformateur (Tr1), d'un second transformateur (Tr2) et d'un troisième transformateur (Tr3) avec un premier condensateur de sortie (C3) qui fournit la première tension de sortie (Out1), avec un second condensateur de sortie (C5) qui fournit la seconde tension de sortie (Out2) et un troisième condensateur de sortie (C6) fournissant la troisième tension de sortie (Out3).

9. Procédé de gestion d'une alimentation à découpage (1) selon l'une des revendications 1 à 7, comme amplificateur avec un coefficient d'amplification, dans lequel
a) on fournit un signal d'entrée (S_{audio}) par une source de tension (S),
b) on forme une différence entre la tension de charge (U_{L}) réduite du coefficient d'amplification et le signal d'entrée (S_{audio}) comme signal de régulation (x),
c) on génère à partir du signal de régulation (x) un signal de signe algébrique (VZ) comme information de direction du signal de régulation (x),
d) on génère en fonction du signal de régulation (x) un premier signal de modulation de largeur d'impulsion MLI (PWM1) et un second signal de modulation de largeur d'impulsion MLI (PWM2),
e) on applique en fonction du signal de signe algébrique (VZ), le premier signal MLI (PWM1) au premier moyen de commutation (T1) et le second signal MLI (PWM2) au second moyen de commutation (T2),
f) pour une largeur d'impulsion MLI du premier signal MLI (PWM1) du premier moyen de commutation (T1) ou du second signal MLI (PWM2) du second moyen de commutation (T2) qui est inférieure à une largeur d'impulsion minimale (PWMₘᵢₙ), on applique en fonction de la configuration de direction affichée par le signal de signe algébrique (VZ) du signal de régulation (x) le second signal MLI (PWM2) au second moyen de commutation (T2) ou le premier signal MLI (PWM1) au premier moyen de commutation (T1).
